(19) Europäisches Patentamt
European Patent Office
Office européen des brevets

(11) **EP 4 282 622 A1**

(12) **EUROPEAN PATENT APPLICATION**

(43) Date of publication:
**29.11.2023 Bulletin 2023/48**

(21) Application number: **22209036.7**

(22) Date of filing: **23.11.2022**

(51) International Patent Classification (IPC):
**B29C 64/129** (2017.01)    **B29C 64/264** (2017.01)
**B33Y 10/00** (2015.01)    **B33Y 30/00** (2015.01)
**F21V 5/04** (2006.01)    **G03B 21/20** (2006.01)
**H01L 33/58** (2010.01)

(52) Cooperative Patent Classification (CPC):
**B29C 64/129; B29C 64/264; B33Y 10/00;**
H01L 33/58

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **24.05.2022 CN 202221264280 U**

(71) Applicant: **Shenzhen Anycubic Technology Co., Ltd.**
**Shenzhen, Guangdong 518116 (CN)**

(72) Inventor: **LU, Sheng Hai**
**Shenzhen (CN)**

(74) Representative: **Bird & Bird LLP**
**Am Sandtorkai 50**
**20457 Hamburg (DE)**

(54) **LIGHT SOURCE OF 3D PRINTER, AND 3D PRINTER**

(57) The present disclosure discloses a 3D printer and a light source of the 3D printer, which adjust propagation angles of light mainly by configuring surface profiles of an incident surface and an emergent surface of a light adjusting element, so that the light can be uniformly projected into a display screen to facilitate uniform curing of a resin. The main technical solution of the present disclosure is: a light source of the 3D printer includes a light source body (100) and a light adjusting element (200), where the light adjusting element includes a first surface and a second surface opposite to each other, the first surface is a convex surface, and the second surface is a concave surface; and the light source body is arranged opposite to the concave surface, and light emitted by the light source body is projected after passing through the light adjusting element.

*FIG. 1*

**Description**

**TECHNICAL FIELD**

The present disclosure relates to the technical field of 3D printing, and in particular to a 3D printer, and a light source of the 3D printer.

**BACKGROUND**

In a photo-curing 3D printer, a resin vat containing a resin is placed on a display screen of the 3D printer, a light source is located on the side of the display screen away from the resin vat, a light beam of the light source is projected into the display screen, projected light covers the whole display region of the display screen, and the light is then projected into the resin in the resin vat through a pattern on the display screen, so that the resin is cured layer by layer according to a pre-set pattern.

The uniformity of the projected light directly affects the curing of the resin. The uniform light makes all resin uniformly cured, which is conductive to improving the printing precision and avoiding failed demolding. However, since the light propagates in the form of a light beam, light in different regions of the light beam have different densities, resulting in non-uniform projected light and thus affecting the effect of curing the resin.

SUMMARY

In view of this, the present disclosure provides a light source of a 3D printer and a 3D printer, which adjust propagation angles of light mainly by configuring surface profiles of an incident surface and an emergent surface of a light adjusting element, so that the light can be uniformly projected into a display screen to facilitate uniform curing of a resin.

In order to achieve the above object, the present disclosure mainly provides the following technical solutions.

In an aspect, the present disclosure provides a light source of a 3D printer, including:

a light source body and a light adjusting element, where
the light adjusting element includes a first surface and a second surface opposite each other, the first surface being a convex surface, and the second surface is a concave surface; and
the light source body is arranged opposite the second surface, and light emitted by the light source body is projected after passing through the light adjusting element.

The second surface includes a first region and a second region that are adjacent to each other, where the first region is a planar surface, the second region circumferentially surrounds the first region, and the first region is closer to the vertex of the first surface than the second region;

the first region and the second region together define a groove having an opening contour that is the same as an outer contour of the first region in shape, and having an opening area greater than the area of the first region; and
the light emitted by the light source body enters the light adjusting element from the first region and the second region, respectively.

The second region has a surface profile selected from one or a combination of a spherical surface, an aspherical surface and a conical surface.

The second region includes a first sub-region, a second sub-region and a third sub-region that are successively adjacent to one another, where the first sub-region circumferentially surrounds the first region, the second sub-region surrounds the first sub-region, and the third sub-region circumferentially surrounds the second sub-region; the second sub-region has a conical surface; and
the first sub-region and the third sub-region each have an arc-shaped surface, the first sub-region and the third sub-region each have a spherical surface, or the first sub-region and the third sub-region each have an aspherical surface.

The light adjusting element further includes a third surface, a fourth surface and a side vertical surface, where

the third surface circumferentially surrounds the first surface, the third surface is a planar surface, and the third surface extends in a direction perpendicular to an optical axis of the light adjusting element;
the fourth surface circumferentially surrounds the second surface, the fourth surface is a planar surface, and the fourth surface extends in the direction perpendicular to the optical axis of the light adjusting element;
the third surface is arranged opposite the fourth surface, and the side vertical surface is connected to the third surface and the fourth surface, respectively; and

the third surface, the fourth surface and the side vertical surface together define a protrusion for fixing the light adjusting element.

A perpendicular distance e between the vertex of the first surface and the fourth surface is greater than or equal to 5 mm and less than or equal to 100 mm; and/or

a perpendicular distance g between the third surface and the fourth surface is greater than or equal to 0.4 mm and less than or equal to 10 mm; and/or

a perpendicular distance f between the vertex of the second surface and the fourth surface is greater than or equal to 0.01e and less than or equal to 0.6e, e representing the perpendicular distance between the vertex of the first surface and the fourth surface; and/or

the perpendicular distance f between the vertex of the second surface and the fourth surface is greater than the perpendicular distance g between the third surface and the fourth surface; and/or

a perpendicular distance d between the vertex of the light source body and the fourth surface is greater than or equal to 0 and less than c, and a tangent plane of the vertex of the light source body is closer to the first surface than the fourth surface, c representing a distance between the vertex of the second surface and the vertex of the light source body.

The light source body comprises a fixing base plate and a light emitting element, the light emitting element being arranged on the fixing base plate, the fixing base plate and the second surface together defining an accommodating cavity, and the light emitting element being located in the accommodating cavity.

The light source body further includes a protective cover; and

the protective cover is arranged outside the light emitting element and is connected to the base plate, and the protective cover is used for protecting the light emitting element.

A distance b between the vertex of the first surface and the vertex of the light source body is greater than or equal to 5 mm and less than or equal to 100 mm; and/or

the distance c between the vertex of the second surface and the vertex of the light source body is greater than 0 and less than b, b representing the distance between the vertex of the first surface and the vertex of the light source body.

At least one of the first surface and the second surface is an aspherical surface, and the aspherical surface meets the following formula:

$$z = \frac{c_x x^2 + c_y y^2}{1 + \sqrt{1 - (1+k_x)c_x^2 x^2 - (1+k_y)c_y^2 y^2}} + \sum_{n=2}^{10} A_{2n}\left[(1-B_{2n})x^2 + (1+B_{2n})y^2\right]^n$$

where $z$ represents a vector height at a point $(x, y)$ on the aspherical surface, $c_x = \dfrac{1}{R_x}$, $c_y = \dfrac{1}{R_y}$, $c_x$ represents a curvature of the vertex of the aspherical surface in an x direction, $R_x$ represents a radius of curvature of the vertex of the aspherical surface in the x direction, $c_y$ represents a curvature of the vertex of the aspherical surface in a y direction, $R_y$ represents a radius of curvature of the vertex of the aspherical surface in the y direction, $k_x$ represents an aspheric coefficient in the x direction, $k_y$ represents an aspheric coefficient in the y direction, $A_{2n}$ and $B_{2n}$ both represent higher-order coefficients of the aspherical surface or correction coefficients of the aspherical surface, and $n$ represents a positive integer greater than 1.

The second surface is an arc-shaped surface, the second surface has a radius of curvature $R_0$ greater than or equal to 5e, e representing a perpendicular distance between the vertex of the first surface and a plane where an edge of the second surface is located.

The light source body includes the fixing base plate and the light emitting element, where the light emitting element is arranged on the fixing base plate; and

the light emitting element is a point light source, the point light source being located on the optical axis of the light adjusting element, or a perpendicular distance between the point light source and the optical axis being less than a distance threshold; or

the light emitting element is a surface light source, the surface light source including a plurality of light emitting chips, a distance between two adjacent light emitting chips being less than a threshold, and a central light emitting chip of the surface light source being located on the optical axis of the light adjusting element, or a perpendicular distance between the central light emitting chip of the surface light source and the optical axis being less than the distance threshold.

The light emitting element is the surface light source, the surface light source including a plurality of light emitting chips, and the distance between two adjacent light emitting chips being less than or equal to 3 mm.

The light emitted by the light source body is uniformly projected after refracted by the light adjusting element.

In another aspect, the present disclosure further provides a 3D printer, including: a light source of a 3D printer of any one of the foregoing embodiments, and

a gate for displaying a pattern of a specific contour, where
the light source of the 3D printer is arranged on a first side of the gate, and light emitted by the light source of the 3D printer is uniformly projected to the gate and pass through the gate to cure a resin.

The gate has an outer display diameter $\delta$, and a perpendicular distance a between the vertex of the first surface and the gate is greater than or equal to $0.2\delta$ and less than or equal to $5\delta$.

The light source of the 3D printer and the 3D printer provided by the present disclosure adjust the propagation angles of light mainly by configuring the surface profiles of the incident surface and the emergent surface of the light adjusting element, so that the light can be uniformly projected into the display screen to facilitate uniform curing of the resin. In the prior art, since light propagates in the form of a light beam, light in different regions of the light beam have different densities, resulting in non-uniform projected light and thus affecting the effect of curing the resin. Compared with the prior art, in the document of the present application, the incident surface of the light adjusting element is configured as the concave surface, the emergent surface of the light adjusting element is configured as the convex surface, and the light emitted by the light source body are refracted twice though the concave surface and the convex surface to change the propagation angles of the light rays, so as to provide the effect of converging the light in the sparse region, so that the refracted light is uniformly projected into the display screen.

**BRIEF DESCRIPTION OF THE DRAWINGS**

FIG. 1 is a schematic structural diagram of a light source and a display screen of a 3D printer according to an embodiment of the present invention;
FIG. 2 is a schematic perspective structural diagram of a light adjusting element according to an embodiment of the present invention, from a first perspective;
FIG. 3 is a schematic perspective structural diagram of a light adjusting element according to an embodiment of the present invention, from a second perspective;
FIG. 4 is a top schematic structural diagram of a light adjusting element according to an embodiment of the present invention;
FIG. 5 is a sectional view of the light adjusting element shown in FIG. 4 along line D-D;
FIG. 6 is a sectional view of the light adjusting element shown in FIG. 4 along line E-E;
FIG. 7 is a schematic diagram showing a dimension of a light adjusting element according to an embodiment of the present invention;
FIG. 8 is a schematic structural diagram of another light adjusting element according to an embodiment of the present invention;
FIG. 9 is a schematic structural diagram of a light source body according to an embodiment of the present invention;
FIG. 10 is a schematic diagram showing a positional relationship of a light source body, a light adjusting element and a display screen according to an embodiment of the present invention; and
FIG. 11 is a schematic diagram of a projection of a light source of a 3D printer on a display screen according to an embodiment of the present invention.

**DETAILED DESCRIPTION OF THE EMBODIMENTS**

In order to further illustrate the technical means adopted to achieve the intended purpose of the present disclosure and the technical effects of the present invention, the specific implementations, structure and features of a light source of a 3D printer disclosed in the present disclosure and the effects thereof are described in detail below in conjunction with the accompanying drawings and the preferred embodiments, as detailed below. For ease of description, light emitted by the light source will be described in the form of light rays.

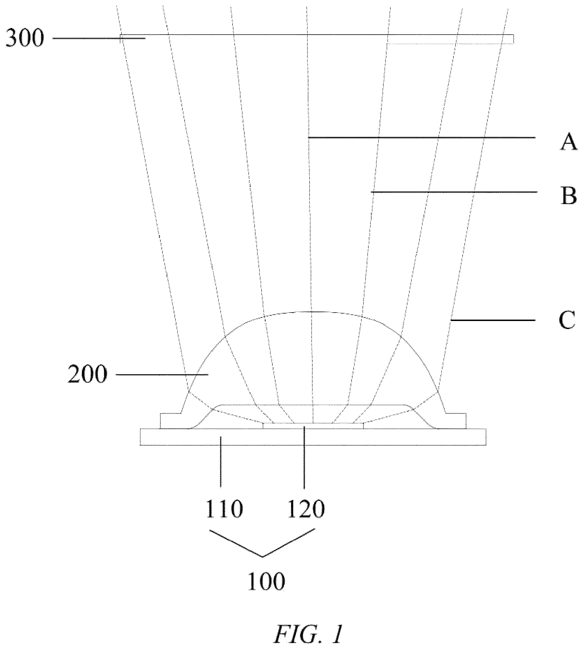

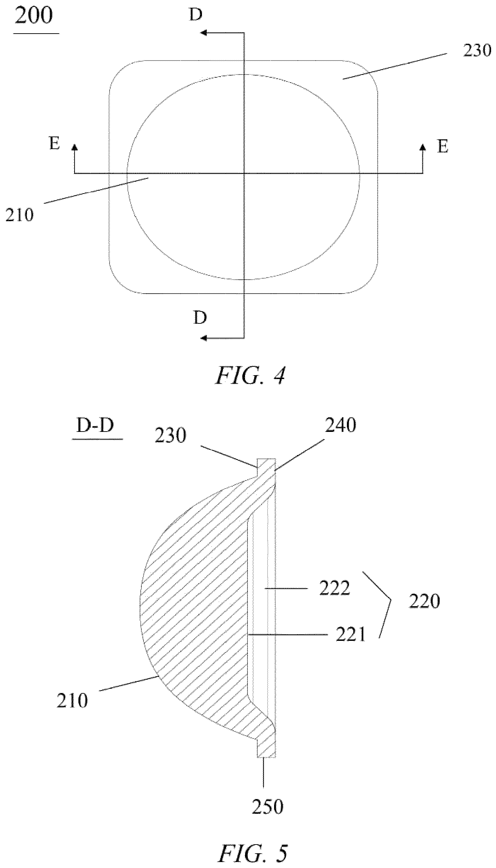

In an aspect, as shown in FIGS. 1-6, embodiments of the present disclosure provide a light source of a 3D printer. The light source of the 3D printer includes a light source body 100 and a light adjusting element 200. The light adjusting element 200 includes a first surface 210 and a second surface 220 opposite each other. The first surface 210 is a convex surface, and the second surface 220 is a concave surface. The light source body 100 is arranged opposite the second surface 220, and light emitted by the light source body 100 is projected after passing through the light adjusting element 200.

In an embodiment, the 3D printer includes a base box. The base box is of a cavity structure, a gate 300 is provided on the base box, the light source is located in the base box, and a resin vat is provided on the side of the gate 300 away from the light source. Slicing data of a printing model is transmitted to the gate 300 one by one by a master controller, the gate 300 allows light of a specific contour to pass through, and the light emitted by the light source is projected into the gate 300, pass through the gate 300, and are then projected into a resin in the resin vat in the form of the specific contour, so that the resin is cured according to the specific contour. For ease of description, as an example, the gate 300 is located at a top end of the base box, and the light from the light source is projected from bottom to top. In addition, it is also possible that the gate 300 is located at a bottom end of the base box body, and the light from the light source are projected from top to bottom. In some embodiments, the gate 300 can be a display screen. Light can be projected into the display screen and passed through the display screen.

The light source body 100 can be in various forms, such as a chip on board (COB) light source, an integrated light source, a laser light source or a mercury lamp. The light source body 100 includes a light emitting element 120 and a fixing base plate 110. The light emitting element 120 can be a point light source or a surface light source including a plurality of light emitting chips, where a distance between two adjacent light emitting chips is less than a threshold, such as a threshold of 3 mm, and the light emitting element 120 is an integrated light source or a COB light source with a maximum distance between the light emitting chips being less than or equal to 3 mm. In this embodiment, as an example, the light emitting element 120 is the point light source or the surface light source with a very small distance between the light emitting chips, for example, the light source body 100 emits light by means of a UV lamp bead or a plurality of light emitting chips with a very small distance therebetween. The light adjusting element 200 is arranged on a light-ray propagation side of the light source body 100, the point light source or a central light emitting chip of the surface light source is located on an optical axis of the light adjusting element 200, or a perpendicular distance between the point light source or the central light emitting chip of the surface light source and the optical axis is less than a distance threshold, and the distance threshold can be 10 mm, ensuring that the light is uniformly adjusted.

The light is refracted through the light adjusting element 200, so that propagation angles of the light are changed, and propagation directions of the light can be adjusted by changing surface profiles of the first surface 210 and the second surface 220 to change refraction angles of the light in different regions, so as to adjust the uniformity of the light projected into a display screen. The light from the light source body 100 propagate outwardly from a light emitting point in the form of a conical light beam. For ease of description below, the first surface 210 of the light adjusting element 200 is referred to as an emergent surface, the second surface 220 is referred to as an incident surface, the light projected into the incident surface are referred to as incident light rays, the light emerging from the emergent surface is referred to as refracted light rays, and the refracted light is projected light projected into the display screen.

The emergent surface is a convex surface, specifically an arc-shaped surface, the incident surface is a concave surface that is recessed towards the emergent surface, and there is a transparent light propagation medium with a light propagation speed different from the speed in the air between the incident surface and the emergent surface. When the light enters the light adjusting element 200 from the incident surface, a first refraction occurs, and the propagation directions of the light is changed for the first time, and when the light emerges from the light adjusting element, a second refraction occurs at the emergent surface, and the propagation directions of the light is changed for the second time. Since the incident surface is the concave surface and the emergent surface is the convex surface, the two refractions of the light are both offset in the same direction to provide the effect of converging the light rays. Thus, densification adjustment of the light in a sparse region is implemented, so that the light is uniform. For example, in an embodiment, the light emitted by the light emitting element 120 is gradually sparse from a central light ray towards an edge of a light beam, and in order to avoid the situation in which the light projected into the display screen gradually weakens from the center to the outside, the light adjusting element 200 is arranged on the light-ray propagation side of the light emitting element 120, and the specific surface profiles of the incident surface and the emergent surface are configured so as to enhance change in angle of the light ray close to the edge of the light beam. As shown in FIG. 1, the propagation angle of the central light ray A does not change, and the propagation angle of the light ray B close to the central light ray A changes slightly, and the propagation angle of the light ray C located at the edge of the light beam changes greatly, that is, the convergence of the light close to the edge of the light beam is gradually strengthened, so that sparse light becomes dense light when being projected into the display screen, and the projected light trends to be uniform.

It will be appreciated that the refracted light in this embodiment includes light propagating at multiple angles, for example, the refracted light still propagates in the form of an approximate light beam, the degrees of uniformity of the light at different positions in the light beam are different due to different propagation directions of the light rays, and a position where the light in the refracted light beam are the most uniform can be found by adjusting the distance between the light source body 100 and the gate 300, which will be described in detail below.

The light source of the 3D printer and the 3D printer provided by the embodiments of the present disclosure adjust the propagation angles of light mainly by configuring the surface profiles of the incident surface and the emergent surface of the light adjusting element, so that the light can be uniformly projected into the display screen to facilitate uniform curing of the resin. In the prior art, since light propagates in the form of a light beam, light in different regions of the light beam has different densities, resulting in non-uniform projected light and thus affecting the effect of curing the resin. Compared with the prior art, in the document of the present application, the incident surface of the light adjusting element is configured as the concave surface, the emergent surface of the light adjusting element is configured as the convex surface, and the light emitted by the light source body is refracted twice though the concave surface and the convex surface to change the propagation angles of the light rays, so as to provide the effect of converging the light in the sparse region, so that the refracted light is uniformly projected into the display screen.

The surface profiles of the first surface 210 and the second surface 220 can be in various forms, and incident angles of the light is adjusted by adjusting the surface profiles of the first surface 210 and the second surface 220, so as to adjust the propagation angles of the refracted light rays, so that the effect of uniformizing the light is achieved. The surface profiles of the first surface 210 and the second surface 220 are related to the arrangement position of the light source body, the type of the light emitting element and the distance between the light source and the display screen, for example, the first surface 210 can be a continuous arc-shaped surface, and the second surface 220 can be a continuous arc-shaped surface or multiple surface profiles connected to each other. In this embodiment, several specific surface profiles are provided.

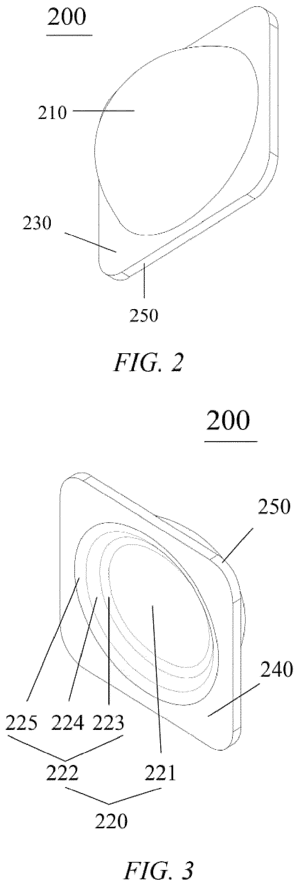

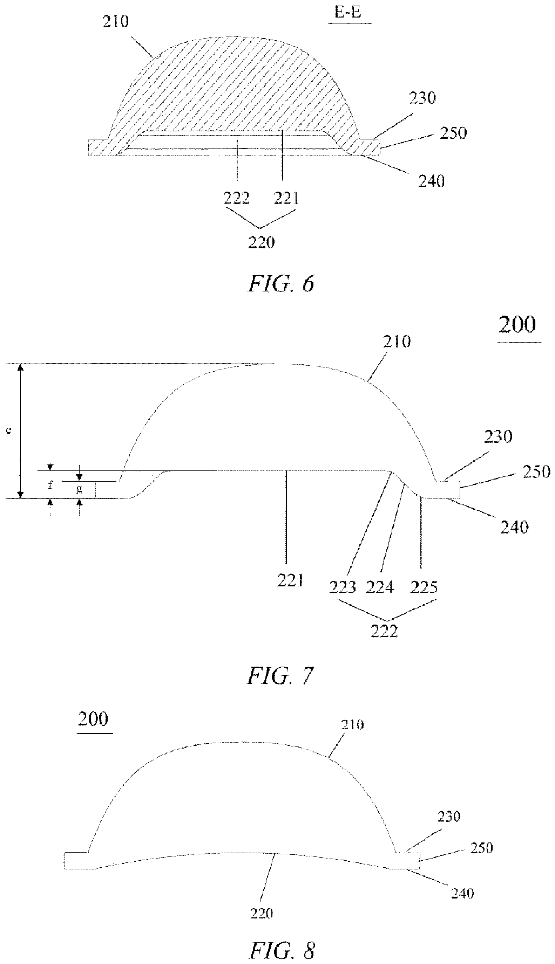

In an embodiment, as shown in FIGS. 3 and 7, the second surface 220 includes a first region 221 and a second region 222 that are adjacent to each other. The first region 221 is a planar surface, the second region 222 circumferentially surrounds the first region 221, and the first region 221 is closer to the vertex of the first surface 210 than the second region 222. The light emitted by the light source body 100 enters the light adjusting element 200 from the first region 221 and the second region 222, respectively.

The first region 221 is a planar surface, the second region 222 is an annular region with a uniform width, and the second region 222 extends from an edge of the first region 221 in a direction away from the optical axis of the light adjusting element 200 and away from the vertex of the first surface 210, so that the first region 221 and the second region 222 together define a groove having an opening contour that is the same as an outer contour of the first region 221 in shape, and having an opening area greater than the area of the first region 221. The second region 222 cooperate with the first surface 210 to provide a strong effect of converging the light rays, so that the light close to an edge region of the light beam is densified. The second region 222 is not limited to one surface profile, and flexible adjustment of the angles of the light incident from the second region 222 can be achieved by adjusting the surface profile of the second region 222 to adapt to light beams of different densities, for example, the second region 222 can have a surface profile selected from one or a combination of a spherical surface, an aspherical surface and a conical surface.

For example, the second region 222 includes a first sub-region 223, a second sub-region 224 and a third sub-region 225 that are successively adjacent to one another. The first sub-region 223 circumferentially surrounds the first region 221, the second sub-region 224 circumferentially surrounds the first sub-region 223, and the third sub-region 225 circumferentially surrounds the second sub-region 224.

In an embodiment, the first sub-region 223 and the third sub-region 225 each have an arc-shaped surface, and the second sub-region 224 has a conical surface. On the one hand, it is convenient to machine the first sub-region 223 and the third sub-region 225, and on the other hand, smooth transition is achieved at a connection position between the first region 221 and the second sub-region 224, and the part of the second sub-region 224 close to an opening of the recess, without an abrupt change in the density of the light rays, and the phenomenon of an annular dark region in a projection is thus avoided.

The first sub-region 223 and the third sub-region 225 can have spherical or aspherical surfaces, for example, ellipsoidal surfaces, and the angles of the light can also be flexibly adjusted by adjusting an aspheric coefficient.

In some other embodiments, as shown in FIG. 8, the second surface 220 can also be a continuous arc-shaped concave surface to allow for continuous adjustment of the light and to avoid the problem of abrupt changes of the light at the junctions of multiple surface profiles, and at least one of the first surface 210 and the second surface 220 can be an aspherical surface in order to increase the focus on the adjustment of the propagation angles of the light rays.

The aspherical surface refers to an arc-shaped surface with inconsistent curvatures at all parts. The curvature changes continuously from the vertex to an edge of the aspherical surface. The surface profile of the aspherical surface can be represented by a higher-order polynomial containing aspheric coefficients, and specifically, the aspherical surface can be of a rotationally symmetrical structure. In some embodiments, the surface profile of the aspherical surface is represented by a polynomial as follows:

$$z = \frac{c_x x^2 + c_y y^2}{1 + \sqrt{1 - (1 + k_x)c_x^2 x^2 - (1 + k_y)c_y^2 y^2}} + \sum_{n=2}^{10} A_{2n}\left[(1 - B_{2n})x^2 + (1 + B_{2n})y^2\right]^n$$

where $z$ represents a vector height at a point $(x, y)$ on the aspherical surface, $c_x = \dfrac{1}{R_x}$, $c_y = \dfrac{1}{R_y}$, $c_x$ represents a curvature of the vertex of the aspherical surface in an x direction, $R_x$ represents a radius of curvature of the vertex of the aspherical surface in the x direction, $c_y$ represents a curvature of the vertex of the aspherical surface in a y direction, $R_y$ represents a radius of curvature of the vertex of the aspherical surface in the y direction, $k_x$ represents an aspheric coefficient in the x direction, and $k_y$ represents an aspheric coefficient in the y direction. When $k_x = k_y = 0$ and $R_x = R_y$, the arc-shaped surface is a spherical surface, $A_{2n}$ and $B_{2n}$ both represent higher-order coefficients of the aspherical surface or correction coefficients of the aspherical surface, the absolute values of A2n and B2n are in the ranges of $0 \le$ A2n $< 1$, $0 \le$ B2n $< 1$, $n = 2, 3, 4...$, and the accurate values of specific parameters are adjusted according to a corresponding scenario, which will not be described in detail herein.

The surface profile of the aspherical surface can be adjusted by adjusting the radius of curvature $R_x$ in the x direction of the vertex of the aspherical surface, the radius of curvature $R_y$ in the y direction of the vertex of the aspherical surface, the aspheric coefficient $k_x$ in the x direction and the aspheric coefficient $k_y$ in the y direction, and the effect of homogenizing the light is thus achieved. For example, the light does not abruptly change at the junctions of the surface profiles by adjusting the surface profiles of the first sub-region 223 and the third sub-region 225, and when the second surface 220 is an arc-shaped surface, at least one of the surface profiles of the first surface 210 and the second surface 220 is adjusted, so that the light is uniform.

The radius of curvature is used to describe the degree of curvature of a curved surface, and it can be approximatively understood that the greater the radius of curvature is, the smaller the degree of curvature of the curved surface is. The radius of curvature of the vertex of the aspherical surface is a main parameter determining the imaging of an aspherical optical system, and affects basic properties of the aspherical surface, such as a focal length of the aspherical surface, and the best optical effect of the aspherical surface can be achieved by adjusting the radius of curvature of the vertex of the aspherical surface. In an embodiment, as shown in FIG. 7, the second surface 220 is an arc-shaped surface, the second surface 220 has a radius of curvature $R_0$ greater than or equal to 5e, where e represents a perpendicular distance between the vertex of the first surface 210 and a plane where an edge of the second surface 220 is located, and the radius of curvature $R_0$ represents a radius of curvature of the vertex of the second surface 220. In some embodiments, the perpendicular distance e between the vertex of the first surface 210 and the plane where the edge of the second surface 220 is located can be approximatively regarded as a distance between the vertex of the first surface 210 and the central light emitting point of the light emitting element 120, and the radius of curvature $R_0$ is greater than or equal to 5e so that the degree of curvature of the second surface 220 is reduced, and the incident angles of the light on the second surface 220 is sufficient to ensure effective refraction of the light by the second surface 220.

In an embodiment, as shown in FIGS 2-7, the light adjusting element 200 further includes a third surface 230, a fourth surface 240, and a side vertical surface 250. The third surface 230 circumferentially surrounds the first surface 210, the third surface 230 is a planar surface, and the third surface 230 extends in a direction perpendicular to the optical axis of the light adjusting element 200. The fourth surface 240 circumferentially surrounds the second surface 220, the fourth surface 240 is a planar surface, and the fourth surface 240 extends in the direction perpendicular to the optical axis of the light adjusting element 200. The third surface 230 is arranged opposite the fourth surface 240, and the side vertical surface 250 is connected to the third surface 230 and the fourth surface 240. The third surface 230, the fourth surface 240 and the side vertical surface 250 together define a protrusion for fixing the light adjusting element 200.

The protrusion is used for fixing the light adjusting element 200, and specifically, the light adjusting element 200 can be fixed by means of an annular fixing member pressing against the third surface 230, so as to avoid drilling in the protrusion for connection. The light from the light source 11 includes stray light with a large angle, which enters the protrusion via the second surface 220, and since the third surface 230 of the protrusion is covered with the annular fixing member, the stray light will be blocked to avoid the influence of the stray light on the projected light rays. In addition, in other embodiments, the third surface 230 can also be coated with a light absorption coating, such as a graphite coating for absorbing stray light.

In order to reduce light loss and enhance the universality of the light adjusting element 200, in some embodiments, as shown in FIG. 7, a perpendicular distance e between the vertex of the first surface 210 and the fourth surface 240 is greater than or equal to 5 mm and less than or equal to 100 mm. Thus, the light adjusting element 200 is moderate in height and easy to machine and does not occupy too much space of the base box, and in addition, since the second surface 220 is a concave surface, e being greater than or equal to 5 mm also enables the light adjusting element 200 to have a sufficient space to machine the concave surface, so as to ensure effective refraction of the concave surface. A perpendicular distance g between the third surface 230 and the fourth surface 240 is greater than or equal to 0.4 mm, so that the large-angle stray light is filtered and the enough connection strength of the light adjusting element 200 is ensured, and g is less than or equal to 10 mm, so that the large-angle light is not excessively filtered and the light intensity of the projected light is not affected. A perpendicular distance f between the vertex of the second surface 220 and the fourth surface 240 is greater than or equal to 0.01e, so as to provide a sufficient space for arranging the light source and to ensure the refraction effect of the second surface 220, and f is less than or equal to 0.6e, so that the distance between the vertex of the first surface 210 and the vertex of the second surface 220 is large enough to ensure that the first surface 210 has a sufficient bending space, and the light is thus effectively refracted by the first surface 210; and/or the perpendicular distance f between the vertex of the second surface 220 and the fourth surface 240 is greater than the perpendicular distance g between the third surface 230 and the fourth surface 240. Taking the direction shown in FIG. 7 as an example, the vertex of the second surface 220 is higher than the third surface 230 to decrease the refracted light blocked by the protrusion, so that the light adjusting element 200 has a large region for light adjustment. In particular, when the second surface 220 includes the first region 221 and the second region 222, the first region 221, namely a planar region, is higher than the third surface 230, so that a large amount of light can be projected to the gate 300 through a region between the second region 222 and the first surface 210, uniform adjustment of the light by a lens is ensured, and the intensity of the light can be ensured.

In an embodiment, the light source body 100 includes a fixing base plate 110 and a light emitting element 120. The light emitting element 120 is arranged on the fixing base plate 110, the fixing base plate 110 and the second surface 220 together define an accommodating cavity, and the light emitting element 120 is located in the accommodating cavity.

The light emitting element 120 is located in the accommodating cavity, so as to avoid the influence of the light from the light emitting element 120 on the projected light rays, and the light from the light emitting element 120 is all projected into the gate 300 through a lens assembly 200, so as to ensure the intensity of the projected light.

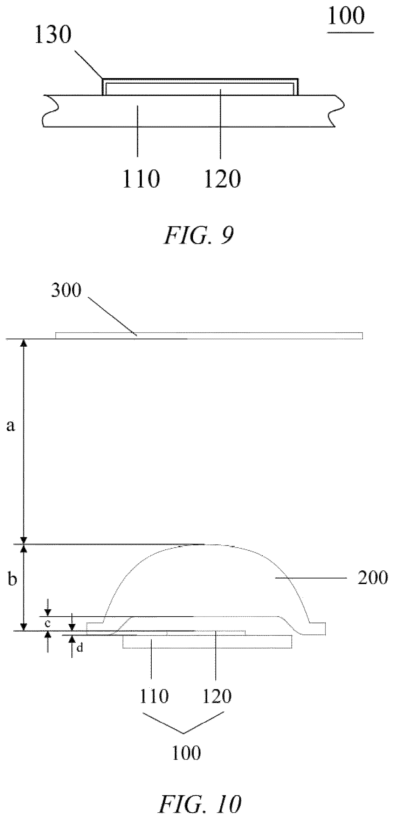

In an embodiment, the fixing base plate 110 is connected to the fourth surface 240, and the light emitting element 120 is located on the fixing base plate 110 such that the light source is approximately centered in the opening of the recess. In some embodiments, as shown in FIG. 10, a distance b between the vertex of the first surface 210 and the vertex of the light source body 100 is greater than or equal to 5 mm and less than or equal to 100 mm, has the same value range as the perpendicular distance e between the vertex of the first surface 210 and the fourth surface 240. However, since the light emitting element 120 has a certain thickness, in practical use, the values of the distance a and the distance e are different, and the difference between the distance a and the distance e is the thickness of the light emitting element 120. In an embodiment, a perpendicular distance d between the vertex of the light source body 100 and the fourth surface 240 is greater than or equal to 0 and less than c, namely, the thickness of the light source body 100 is greater than or equal to 0 and less than c, where c represents a distance between the vertex of the second surface 220 and the vertex of the light source body 100, and the distance c between the vertex of the second surface 220 and the vertex of the light source body 100 is greater than 0 and less than b. By means of the above-mentioned distance relationships, a distance between the vertex of the light source 11 and the vertex of the second surface 220 is sufficient to ensure that the light has a sufficient distance to spread before entering the light adjusting element 200, so as to ensure that the area of the projected light can cover a display region of the display screen.

In an embodiment, as shown in FIG. 9, the light source body 100 further includes a protective cover 130. The protective cover 130 is arranged outside the light emitting element 120 and is connected to the base plate 110, and the protective cover 130 is used for protecting the light emitting element 120.

In some embodiments, the protective cover 130 includes a cavity having a lower opening, and the protective cover 130 covers the light emitting element 120 from the lower opening and is fixed to the base plate 110 so that the light emitting element 120 is located in the cavity to provide the effect of protecting the light emitting element 120. The material of the protective cover 130 includes acrylic.

It will be appreciated that a tangent plane of the vertex of the light source body 100 is closer to the first surface 210 than the fourth surface 240 so that the light source body 100 is located inside the accommodating cavity. When the second surface 220 includes the planar first region 221, the vertex of the second surface 220 refers to the central point of the first region 221, and the central point of the first region 221 is located on the optical axis of the light adjusting element 200.

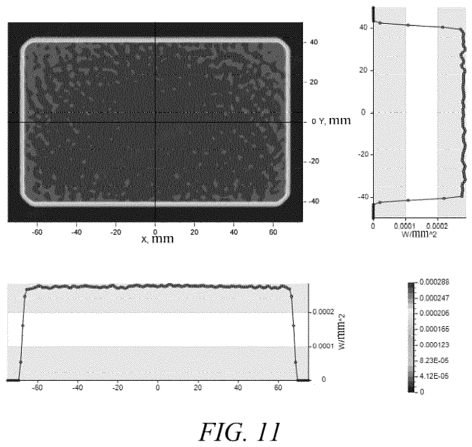

It will be appreciated that in the above description of the embodiments, the above-mentioned structural arrangements and distance ranges do not present separately, but mutually restrict to jointly enable the adjustment of the propagation angles of the light rays, so that the projected light shows good uniformity. As shown in FIG. 11, in a coordinate system, the abscissa represents the position on the display screen, and the ordinate represents a radiant illuminance, and it can be seen from the figure that the radiant illuminance is uniform in the display region of the gate 300, and uniform curing of the resin can be achieved.

In another aspect, the embodiments of the present disclosure further provide a 3D printer. The 3D printer includes a light source of a 3D printer of any one of the foregoing embodiments, and a gate 300. The gate 300 is used for displaying a pattern of a specific contour. The light source of the 3D printer is arranged on a first side of the gate 300, and light emitted by the light source of the 3D printer is projected into the gate 300 and pass through the gate 300 to cure a resin.

In an embodiment, the gate 300 has an outer display diameter $\delta$, and a perpendicular distance a between the vertex of the first surface 210 and the gate 300 is greater than or equal to 0.2 x $\delta$ and less than or equal to 5 x $\delta$.

The outer display diameter $\delta$ is the diameter of a circumscribed circle of a display region of the gate 300. The specific value of the distance a is related to the size of the light adjusting element 200 and the position of the light source body 100 relative to the light adjusting element. The distance between the light source body 100 and the light adjusting element 200 and the gate 300 is adjusted to observe or evaluate the uniformity of the projected light by using a radiant illuminance measuring instrument, so as to find a position where the projection uniformity is the best. In this embodiment, on the basis of the above ranges of the distances, the perpendicular distance a between the vertex of the first surface 210 and the gate 300 is set to be greater than or equal to 0.2$\delta$ and less than or equal to 5$\delta$ in order to ensure that the projected light has a sufficient projection area to cover the display region and to avoid light loss caused by the light source body 100 being too far away from the gate 300.

In an aspect, the present disclosure provides the following embodiments.

Embodiment 1: A light source of a 3D printer, including:

a light source body 100 and a light adjusting element 200, where
the light adjusting element 200 includes a first surface 210 and a second surface 220 opposite each other, the first surface 210 being a convex surface, and the second surface 220 being a concave surface; and
the light source body 100 is arranged opposite the second surface 220, and light emitted by the light source body 100 is projected after refracted by the light adjusting element 200.

Embodiment 2: The light source of the 3D printer according to term 1, where the second surface 220 includes a first region 221 and a second region 222, and where the first region 221 is a planar surface, the second region 222 circumferentially surrounds the first region 221, and the first region 221 is closer to the vertex of the first surface 210 than the second region 222;

the first region 221 and the second region 222 together define a groove having an opening contour that is the same as an outer contour of the first region 221 in shape, and having an opening area greater than the area of the first region 221; and
the light emitted by the light source body 100 enters the light adjusting element 200 from the first region 221 and the second region 222, respectively.

Embodiment 3: The light source of the 3D printer according to term 2, where the second region 222 has a surface profile selected from one or a combination of a spherical surface, an aspherical surface and a conical surface.

Embodiment 4: The light source of the 3D printer according to term 2, where the second region 222 includes a first sub-region 223, a second sub-region 224 and a third sub-region 225, and where the first sub-region 223 circumferentially surrounds the first region 221, the second sub-region 224 circumferentially surrounds the first sub-region 223, and the third sub-region 225 circumferentially surrounds the second sub-region 224;

the second sub-region 224 has a conical surface; and
the first sub-region 223 and the third sub-region 225 each have an arc-shaped surface, the first sub-region 223 and the third sub-region 225 each have a spherical surface, or the first sub-region 223 and the third sub-region 225 each have an aspherical surface.

Embodiment 5: The light source of the 3D printer according to term 1, where the light adjusting element 200 further includes a third surface 230, a fourth surface 240 and a side vertical surface 250, and where

the third surface 230 circumferentially surrounds the first surface 210, the third surface 230 is a planar surface, and the third surface 230 extends in a direction perpendicular to an optical axis of the light adjusting element 200;
the fourth surface 240 circumferentially surrounds the second surface 220, the fourth surface 240 is a planar surface, and the fourth surface 240 extends in the direction perpendicular to the optical axis of the light adjusting element 200;
the third surface 230 is arranged opposite the fourth surface 240, and the side vertical surface 250 is connected to the third surface 230 and the fourth surface 240, respectively; and
the third surface 230, the fourth surface 240 and the side vertical surface 250 together define a protrusion for fixing the light adjusting element 200.

Embodiment 6: The light source of the 3D printer according to term 5, where a perpendicular distance e between the vertex of the first surface 210 and the fourth surface 240 is greater than or equal to 5 mm and less than or equal to 100 mm; and/or

a perpendicular distance g between the third surface 230 and the fourth surface 240 is greater than or equal to 0.4 mm and less than or equal to 10 mm; and/or

a perpendicular distance f between the vertex of the second surface 220 and the fourth surface 240 is greater than or equal to 0.01e and less than or equal to 0.6e, e representing the perpendicular distance between the vertex of the first surface 210 and the fourth surface 240; and/or

the perpendicular distance f between the vertex of the second surface 220 and the fourth surface 240 is greater than the perpendicular distance g between the third surface 230 and the fourth surface 240.

Embodiment 7: The light source of the 3D printer according to term 5, where a perpendicular distance d between the vertex of the light source body 100 and the fourth surface 240 is greater than or equal to 0 and less than c, and a tangent plane of the vertex of the light source body 100 is closer to the first surface 210 than the fourth surface 240, c representing a distance between the vertex of the second surface 220 and the vertex of the light source body 100.

Embodiment 8: The light source of the 3D printer according to term 1, where the light source body 100 includes a fixing base plate 110 and a light emitting element 120, the light emitting element 120 being arranged on the fixing base plate 110, the fixing base plate 110 being connected to the fourth surface 240, the fixing base plate 110 and the second surface 220 together defining an accommodating cavity, and the light emitting element 120 being located in the accommodating cavity.

Embodiment 9: The light source of the 3D printer according to Embodiment 1, where the light source body 100 further includes a protective cover 130, and where the protective cover 130 is arranged outside the light emitting element 120 and is connected to the base plate 110, and the protective cover 130 is used for protecting the light emitting element 120.

Embodiment 10: The light source of the 3D printer according to embodiment 1, where a distance b between the vertex of the first surface 210 and the vertex of the light source body 100 is greater than or equal to 5 mm and less than or equal to 100 mm; and/or

a distance c between the vertex of the second surface 220 and the vertex of the light source body 100 is greater than 0 and less than b, b representing the distance between the vertex of the first surface 210 and the vertex of the light source body 100.

Embodiment 11: The light source of the 3D printer according to embodiment 1, where at least one of the first surface 210 and the second surface 220 is an aspherical surface, and the aspherical surface meets the following formula:

$$z = \frac{c_x x^2 + c_y y^2}{1 + \sqrt{1 - (1 + k_x) c_x^2 x^2 - (1 + k_y) c_y^2 y^2}} + \sum_{n=2}^{10} A_{2n} \left[ (1 - B_{2n}) x^2 + (1 + B_{2n}) y^2 \right]^n$$

where $z$ represents a vector height at a point $(x, y)$ on the aspherical surface, $c_x = \dfrac{1}{R_x}$, $c_y = \dfrac{1}{R_y}$, $c_x$ represents a curvature of the vertex of the aspherical surface in an x direction, $R_x$ represents a radius of curvature of the vertex of the aspherical surface in the x direction, $c_y$ represents a curvature of the vertex of the aspherical surface in a y direction, $R_y$ represents a radius of curvature of the vertex of the aspherical surface in the y direction, $k_x$ represents an aspheric coefficient in the x direction, $k_y$ represents an aspheric coefficient in the y direction, $A_{2n}$ and $B_{2n}$ both represent higher-order coefficients of the aspherical surface or correction coefficients of the aspherical surface, and $n$ represents a positive integer greater than 1.

Embodiment 12: The light source for the 3D printer according to embodiment 1, where the second surface 220 is an arc-shaped surface, the second surface 220 has a radius of curvature $R_0$ greater than or equal to 5e, e representing a perpendicular distance between the vertex of the first surface 210 and a plane where an edge of the second surface 220 is located.

Embodiment 13: The light source of the 3D printer according to embodiment 1, where the light source body

100 includes a fixing base plate 110 and a light emitting element 120, and where the light emitting element 120 is arranged on the fixing base plate 110; and the light emitting element 120 is a point light source, the point light source being located on an optical axis of the light adjusting element 200, or a perpendicular distance between the point light source and the optical axis being less than a distance threshold; or the light emitting element 120 is a surface light source, the surface light source including a plurality of light emitting chips, a distance between two adjacent light emitting chips being less than a threshold, and a central light emitting chip of the surface light source being located on the optical axis of the light adjusting element 200, or a perpendicular distance between the central light emitting chip of the surface light source and the optical axis being less than the distance threshold.

Embodiment 14: The light source of the 3D printer according to embodiment 1, where the light emitting element 120 is a surface light source, the surface light source including a plurality of light emitting chips, and a distance between two adjacent light emitting chips being less than or equal to 3 mm.

Embodiment 15: The light source of the 3D printer according to embodiment 1, where the light emitted by the light source body 100 is uniformly projected after refracted by the light adjusting element 200.

In another aspect, the present disclosure provides the following embodiment 16.

Embodiment 16: A 3D printer, including a light source of a 3D printer of any one of embodiments 1-15, and

a gate 300, the gate 300 being used for displaying a pattern of a specific contour, where
the light source of the 3D printer is arranged on a first side of the gate 300, and light emitted by the light source of the 3D printer is uniformly projected into the gate 300 and pass through the gate 300 to cure a resin.

Embodiment 17: The 3D printer according to embodiment 16, where the gate 300 has an outer display diameter $\delta$, and a perpendicular distance a between the vertex of the first surface 210 and the gate 300 is greater than or equal to $0.2\delta$ and less than or equal to $5\delta$.

The foregoing description merely relates to specific embodiments of the present invention, but the scope of protection of the present disclosure is not limited thereto. Changes or substitutions that can be easily conceived by those skilled in the art within the technical scope disclosed in the present disclosure shall fall within the scope of protection of the present invention. Therefore, the scope of protection of the present disclosure shall be subject to the scope of protection of the claims.

**Claims**

1. A light source of a 3D printer, comprising:

   a light source body (100) and a light adjusting element (200), wherein
   the light adjusting element (200) comprises a first surface (210) and a second surface (220) opposite each other, the first surface (210) being a convex surface, and the second surface (220) being a concave surface; and
   the light source body (100) is arranged opposite the second surface (220), and light emitted by the light source body (100) is projected after refracted by the light adjusting element (200).

2. The light source of the 3D printer according to claim 1, wherein

   the second surface (220) comprises a first region (221) and a second region (222), the first region (221) is a planar surface, the second region (222) circumferentially surrounds the first region (221), and the first region (221) is closer to the vertex of the first surface (210) than the second region (222);
   the first region (221) and the second region (222) together define a groove having an opening contour that is the same as an outer contour of the first region (221) in shape, and having an opening area greater than the area of the first region (221); and
   the light emitted by the light source body (100) enters the light adjusting element (200) from the first region (221) and the second region (222), respectively.

3. The light source of the 3D printer according to claim 2, wherein
   the second region (222) has a surface profile selected from one or a combination of a spherical surface, an aspherical surface and a conical surface.

4. The light source of the 3D printer according to claim 2, wherein

   the second region (222) comprises a first sub-region (223), a second sub-region (224) and a third sub-region, the first sub-region (223) circumferentially surrounds the first region (221), the second sub-region (224) circumferentially surrounds the first sub-region (223), and the third sub-region (225) circumferentially surrounds the second sub-region (224);

the second sub-region (224) has a conical surface; and

the first sub-region (223) and the third sub-region (224) each have an arc-shaped surface, the first sub-region (223) and the third sub-region (224) each have a spherical surface, or the first sub-region (223) and the third sub-region (224) each have an aspherical surface.

5. The light source of the 3D printer according to claim 1, wherein

the light adjusting element (200) further comprises a third surface (230), a fourth surface (240) and a side vertical surface (250), and wherein

the third surface (230) circumferentially surrounds the first surface (210), the third surface (230) is a planar surface, and the third surface (230) extends in a direction perpendicular to an optical axis of the light adjusting element (200);

the fourth surface (240) circumferentially surrounds the second surface (220), the fourth surface (240) is a planar surface, and the fourth surface (240) extends in the direction perpendicular to the optical axis of the light adjusting element (200);

the third surface (230) is arranged opposite the fourth surface (240), and the side vertical surface (250) is connected to the third surface (230) and the fourth surface (240), respectively; and

the third surface (230), the fourth surface (240) and the side vertical surface (250) together define a protrusion for fixing the light adjusting element (200).

6. The light source of the 3D printer according to claim 5, wherein

a perpendicular distance e between the vertex of the first surface (210) and the fourth surface (240) is greater than or equal to 5 mm and less than or equal to 100 mm; and/or

a perpendicular distance g between the third surface (230) and the fourth surface (240) is greater than or equal to 0.4 mm and less than or equal to 10 mm; and/or

a perpendicular distance f between the vertex of the second surface (220) and the fourth surface (240) is greater than or equal to 0.01e and less than or equal to 0.6e, e representing the perpendicular distance between the vertex of the first surface (210) and the fourth surface (240); and/or

the perpendicular distance f between the vertex of the second surface (220) and the fourth surface (240) is greater than the perpendicular distance g between the third surface (230) and the fourth surface (240); and/or

a perpendicular distance d between the vertex of the light source body (100) and the fourth surface (240) is greater than or equal to 0 and less than c, and a tangent plane of the vertex of the light source body (100) is closer to the first surface (210) than the fourth surface (240), c representing a distance between the vertex of the second surface (220) and the vertex of the light source body (100).

7. The light source of the 3D printer according to claim 1, wherein
the light source body (100) comprises a fixing base plate (110) and a light emitting element (120), the light emitting element (120) being arranged on the fixing base plate (110), the fixing base plate (110) and the second surface (220) together defining an accommodating cavity, and the light emitting element (120) being located in the accommodating cavity.

8. The light source of the 3D printer according to claim 1, wherein

the light source body (100) further comprises a protective cover (130); and

the protective cover (130) is arranged outside the light emitting element (120) and is connected to the base plate (110), and the protective cover (130) is used for protecting the light emitting element (120).

9. The light source of the 3D printer according to claim 1, wherein a distance b between the vertex of the first surface (210) and the vertex of the light source body (100) is greater than or equal to 5 mm, the distance b between the vertex of the first surface (210) and the vertex of the light source body (100) is less than or equal to 100 mm; and/or

a distance c between the vertex of the second surface (220) and the vertex of the light source body (100) is greater than 0mm, the distance c between the vertex of the second surface (220) and the vertex of the light source body (100) is less than the distance b.

**10.** The light source of the 3D printer according to claim 1, wherein at least one of the first surface (210) and the second surface (220) is an aspherical surface, and the aspherical surface meets the following formula:

$$z = \frac{c_x x^2 + c_y y^2}{1 + \sqrt{1 - (1+k_x)c_x^2 x^2 - (1+k_y)c_y^2 y^2}} + \sum_{n=2}^{10} A_{2n}\left[(1-B_{2n})x^2 + (1+B_{2n})y^2\right]^n$$

where $z$ represents a vector height at a point $(x, y)$ on the aspherical surface, $c_x = \dfrac{1}{R_x}$, $c_y = \dfrac{1}{R_y}$, $c_x$ represents a curvature of the vertex of the aspherical surface in an x direction, $R_x$ represents a radius of curvature of the vertex of the aspherical surface in the x direction, $c_y$ represents a curvature of the vertex of the aspherical surface in a y direction, $R_y$ represents a radius of curvature of the vertex of the aspherical surface in the y direction, $k_x$ represents an aspheric coefficient in the x direction, $k_y$ represents an aspheric coefficient in the y direction, $A_{2n}$ and $B_{2n}$ both represent higher-order coefficients of the aspherical surface or correction coefficients of the aspherical surface, and $n$ represents a positive integer greater than an integer 1.

**11.** The light source for the 3D printer according to claim 1, wherein the second surface (220) is an arc-shaped surface, the second surface (220) has a radius of curvature $R_0$ greater than or equal to 5e, e representing a perpendicular distance between the vertex of the first surface (210) and a plane where an edge of the second surface (220) is located.

**12.** The light source of the 3D printer according to claim 1, wherein the light source body (100) includes a fixing base plate (110) and a light emitting element (120), the light emitting element (120) is arranged on the fixing base plate (110); and

the light emitting element (120) is a point light source, the point light source is located on an optical axis of the light adjusting element (200), or a perpendicular distance between the point light source and the optical axis is less than a distance threshold; or
the light emitting element (120) is a surface light source, the surface light source comprises a plurality of light emitting chips, a distance between two adjacent light emitting chips are less than a threshold, and a central light emitting chip of the surface light source being located on the optical axis of the light adjusting element (200), or a perpendicular distance between the central light emitting chip of the surface light source and the optical axis is less than the distance threshold.

**13.** The light source of the 3D printer according to claim 1, wherein the light emitting element (120) is a surface light source, the surface light source comprises a plurality of light emitting chips, and a distance between two adjacent light emitting chips is less than or equal to 3 mm.

**14.** A 3D printer, comprising: a light source of a 3D printer of any one of claims 1-13, and

a gate (300) for displaying a pattern of a specific contour, wherein
the light source of the 3D printer is arranged on a first side of the gate (300), and light emitted by the light source of the 3D printer is uniformly projected to the gate (300) and passes through the gate (300) to cure a resin.

**15.** The 3D printer according to claim 14, wherein
the gate (300) has an outer display diameter $\delta$, and a perpendicular distance a between the vertex of the first surface (210) and the gate (300) is greater than or equal to $0.2\delta$ and less than or equal to $5\delta$.

300

A

B

C

200

110    120

100

*FIG. 1*

FIG. 2

FIG. 3

200

D

E     E

210

230

FIG. 4

D-D   230     240

222

220

221

210

250

FIG. 5

E-E

210

230

250

240

222 221

220

*FIG. 6*

200

210

e

f

g

230

250

240

221 223 224 225

222

*FIG. 7*

200

210

230

250

240

220

*FIG. 8*

130

100

110 120

*FIG. 9*

300

a

b

c

d

200

110 120

100

*FIG. 10*

*FIG. 11*

Europäisches Patentamt

European Patent Office

Office européen des brevets

# EUROPEAN SEARCH REPORT

Application Number

EP 22 20 9036

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/299525 A1 (LEE SANG CHUL [KR] ET AL) 3 October 2019 (2019-10-03) * paragraphs [0001], [0053], [0054], [0055]; figures 3,4 * | 1-15 | INV. B29C64/129 B29C64/264 B33Y10/00 B33Y30/00 F21V5/04 G03B21/20 H01L33/58 |
| X | CN 108 089 394 A (DONG GUAN LONGIDEAL IND CO LTD) 29 May 2018 (2018-05-29) * figures 14,15 * | 1-15 | |
| A | WO 2020/125232 A1 (SHENZHEN ANYCUBIC TECH CO LTD [CN]) 25 June 2020 (2020-06-25) * paragraph [0003] * | 14 | |
| A | CN 110 978 499 A (SHENZHEN ANYCUBIC TECH CO LTD) 10 April 2020 (2020-04-10) * the whole document * | 14 | |
| A | US 2018/036941 A1 (XU BEIBEI [CN] ET AL) 8 February 2018 (2018-02-08) * figures 4a-4c * | 5,7,8, 12,13 | |
| X,P | CN 115 122 637 A (SHENZHEN ANYCUBIC TECH CO LTD) 30 September 2022 (2022-09-30) * the whole document * | 1-15 | TECHNICAL FIELDS SEARCHED (IPC) B29C G03B F21V |

The present search report has been drawn up for all claims

| Place of search | Date of completion of the search | Examiner |
|---|---|---|
| The Hague | 26 May 2023 | Hartwell, Ian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.................................................................................................

& : member of the same patent family, corresponding document

EPO FORM 1503 03.82 (P04C01)

## EP 4 282 622 A1

### ANNEX TO THE EUROPEAN SEARCH REPORT
### ON EUROPEAN PATENT APPLICATION NO.

EP 22 20 9036

This annex lists the patent family members relating to the patent documents cited in the above-mentioned European search report.
The members are as contained in the European Patent Office EDP file on
The European Patent Office is in no way liable for these particulars which are merely given for the purpose of information.

26-05-2023

| Patent document cited in search report | | Publication date | Patent family member(s) | | Publication date |
|---|---|---|---|---|---|
| US 2019299525 | A1 | 03-10-2019 | EP | 3427929 A1 | 16-01-2019 |
| | | | ES | 2903238 T3 | 31-03-2022 |
| | | | JP | 6757801 B2 | 23-09-2020 |
| | | | JP | 2019514722 A | 06-06-2019 |
| | | | KR | 101800667 B1 | 20-12-2017 |
| | | | US | 2019299525 A1 | 03-10-2019 |
| | | | WO | 2018117351 A1 | 28-06-2018 |
| CN 108089394 | A | 29-05-2018 | CN | 108089394 A | 29-05-2018 |
| | | | WO | 2019080506 A1 | 02-05-2019 |
| WO 2020125232 | A1 | 25-06-2020 | CN | 109454866 A | 12-03-2019 |
| | | | WO | 2020125232 A1 | 25-06-2020 |
| CN 110978499 | A | 10-04-2020 | NONE | | |
| US 2018036941 | A1 | 08-02-2018 | CN | 107428076 A | 01-12-2017 |
| | | | EP | 3290186 A1 | 07-03-2018 |
| | | | US | 2018036941 A1 | 08-02-2018 |
| | | | WO | 2016173100 A1 | 03-11-2016 |
| CN 115122637 | A | 30-09-2022 | NONE | | |